Europäisches Patentamt

European Patent Office

Office européen des brevets

(11) Publication number: **0 189 295**
A2

# (12) EUROPEAN PATENT APPLICATION

(21) Application number: 86300344.8

(22) Date of filing: 20.01.86

(51) Int. Cl.⁴: **H 01 S 3/103**

(30) Priority: 22.01.85 JP 10073/84

(43) Date of publication of application: 30.07.86
Bulletin 86/31

(84) Designated Contracting States: **DE GB NL**

(71) Applicant: **SHARP KABUSHIKI KAISHA,
22-22 Nagaike-cho Abeno-ku, Osaka 545 (JP)**

(72) Inventor: **Takiguchi, Haruhisa, 7-98, Aoyama, Nara-shi
Nara-ken (JP)**
Inventor: **Kaneiwa, Shinji, 101 Kyobate
Mansion 182-2, 1-chome, Minamikyobate-cho Nara-shi
Nara-ken (JP)**
Inventor: **Matsui, Sadayoshi, 289-53, Nishinagara-cho,
Tenri-shi Nara-ken (JP)**
Inventor: **Yoshida, Toshihiko, 2613-1 Ichinomoto-cho,
Tenri-shi Nara-ken (JP)**

(74) Representative: **Billington, Lawrence Emlyn et al,
HASELTINE LAKE & CO Hazlitt House 28 Southampton
Buildings Chancery Lane, London WC2A 1AT (GB)**

(54) A signal modulation mode for a semiconductor laser.

(57) A signal modulation mode for a semiconductor laser wherein a high-frequency signal current (6) which is amplitude-modulated by signals (2) to be transmitted is applied to the semiconductor laser with a bias current (4) set at around the threshold current level (3), resulting in a modulated output power light (5).

# A SIGNAL MODULATION MODE FOR A SEMICONDUCTOR LASER

This invention relates to a signal modulation mode for a semiconductor laser, particularly but not necessarily exclusively to an analog modulation mode for a semiconductor laser.

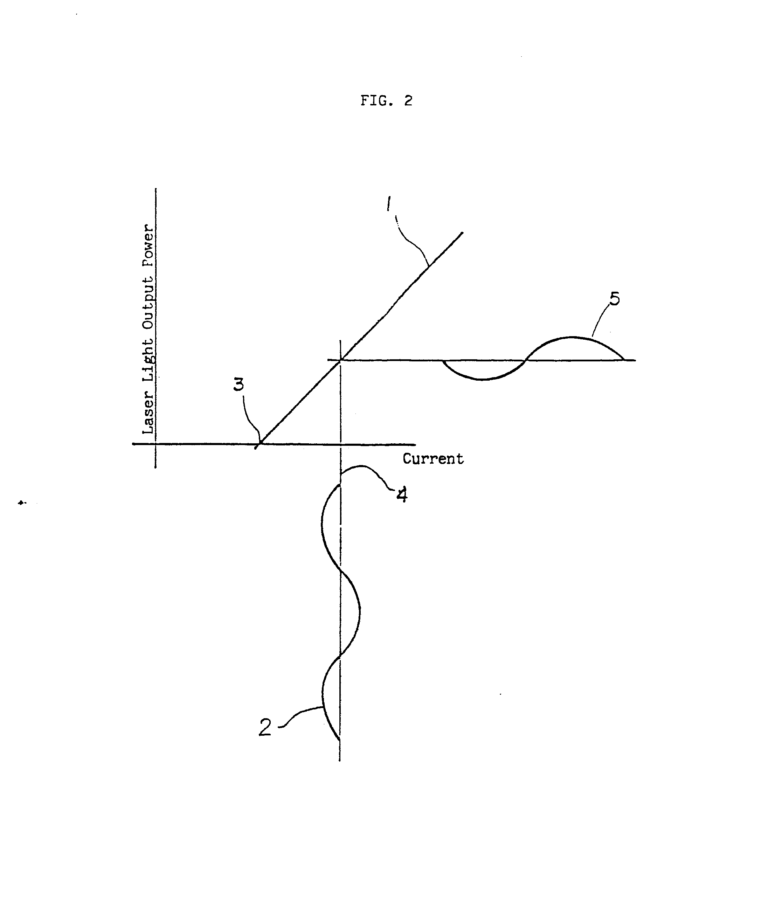

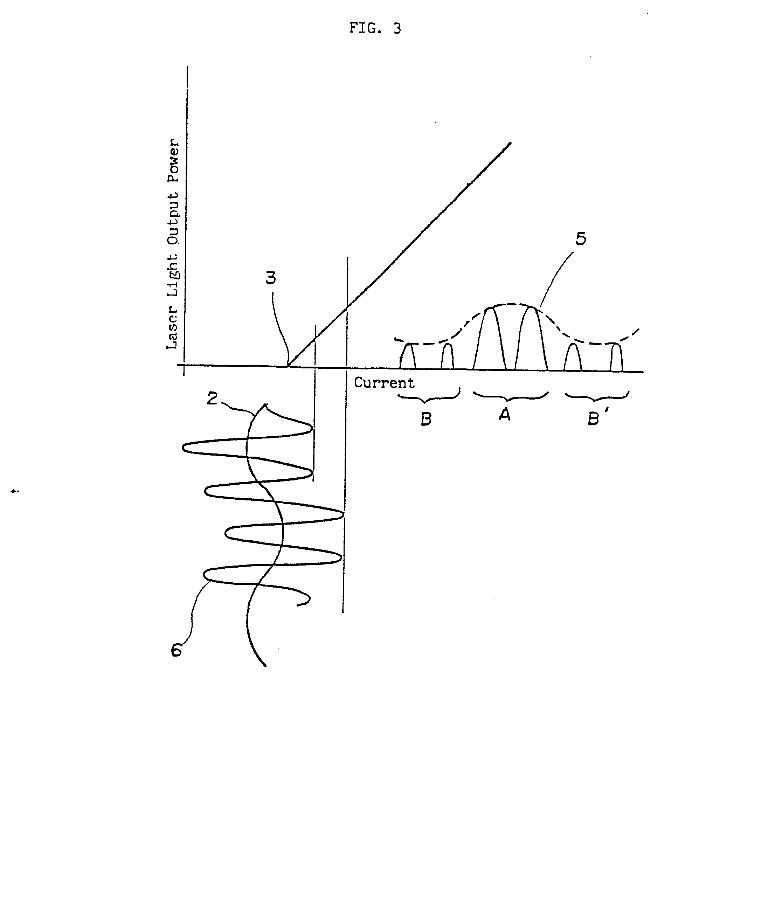

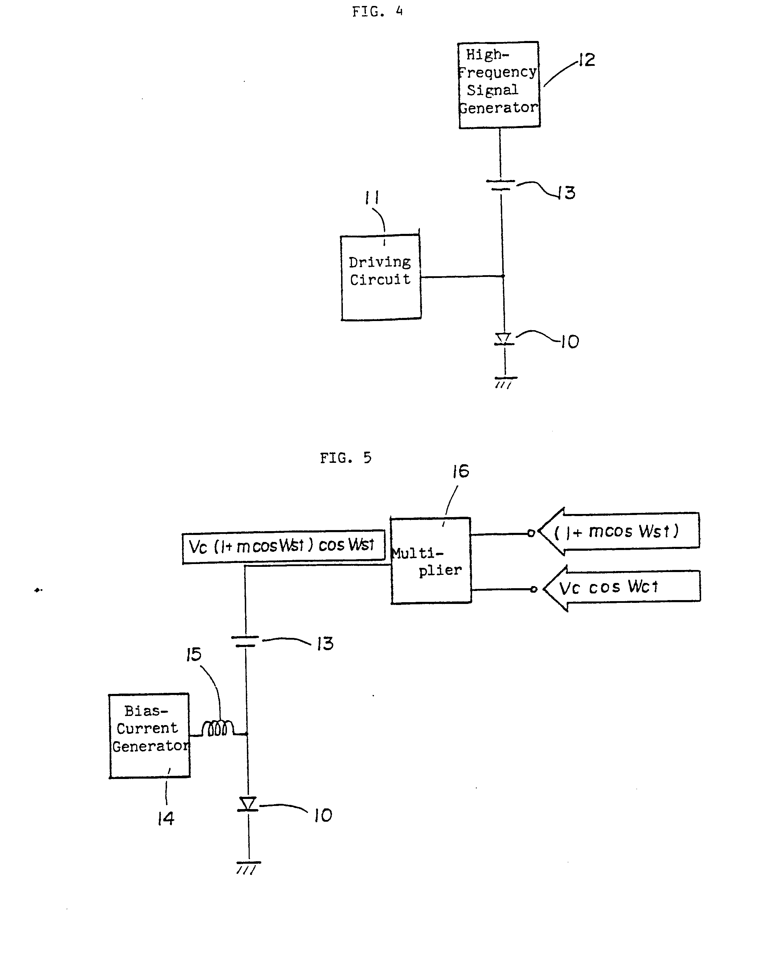

A driving mode such as that shown in Figures 2 and 3 for the analog modulation mode of semiconductor lasers is known. In Figure 2, reference numeral 1 is the characteristic curve showing the relationship between the current and the laser light output power, reference numeral 2 is the curve for the input current of the analog signal, reference numeral 3 is the lasing threshold current of a semiconductor laser, and reference numeral 5 is the curve for the light output power signal when the analog signal current 2 is driving the semiconductor laser. When a bias current 4 is set higher than the lasing threshold current 3 and the semiconductor laser is driven by the analog signal current 2, the modulated laser light output power signal 5 is obtained. When the bias current 4 of the semiconductor laser is set higher than the lasing threshold current 3, the semiconductor laser generally lases in a single longitudinal mode. In analog transmission where a single-longitudinal-mode semiconductor laser is driven by the analog signal current 2, the transmission fibers move or the lasing wavelength of the semiconductor laser changes, giving rise to modal noise and/or reflection noise. This causes the problem known as deterioration of the analog signal curve of the light output power. To solve this problem, a driving mode, which can be used even for single-longitudinal-mode semiconductor lasers to achieve analog transmission by setting the bias current of the semiconductor laser at a level lower than the lasing threshold current 3 and superposing the high-frequency current 6 on the analog signal current 2, has been proposed in Japanese Patent Publication No. 59-14936. The high-frequency current 6, which is superposed on the analog signal current 2, has an amplitude that changes above and below the lasing threshold current 3 and has an extremely high frequency as compared to the analog signal current 2. Figure 4 is a circuit diagram showing the working of the modulation mode shown in Figure 3. Driving current is applied from a driving circuit 11 to a semiconductor laser 10 with a bias current set at below the threshold current. A high-frequency current of several hundreds of MHz obtained from a high-frequency generator 12 is superposed on this driving circuit via a condenser 13 and applied to the semiconductor laser 10, and thus the semiconductor laser 10 lases in multi longitudinal modes as is well known. When the semiconductor laser lases in multi longitudinal modes, modal noise and reflection noise are reduced. However, with this conventional mode involving superposition of high-frequency currents, there is the disadvantage in actual application of the linearity being poor. That is, the duty cycle of a light output power pulse 5 radiated by the semiconductor laser, as shown in Figure 3, changes depending upon the analog signal current 2. On the receiving side, the light output pulse 5 is received by a light detector to be converted into a pulse current, which is then passed through a low-pass filter to pick up signals therefrom. The signals are equivalent to changes over time of the integrated value of the light detection pulse current. For this reason, if the duty cycle of the light output power pulse changes, the linear relationship between the changes over time of the integrated value of the light detection pulse current and the signals cannot be maintained. That is, the receiving signal in range A shown in Figure 3 is relatively larger and that of ranges B and B' are relatively smaller. This is the reason for the significant problem arising in the linearity of the relationship when the conventional modulation mode shown in Figure 3 is used in practice.

According to the present invention there is provided a signal modulation mode for a semiconductor laser wherein a high-frequency signal current which is amplitude-modulated by signals to be transmitted is applied to the semiconductor laser with a bias current set at around the threshold current level, resulting in a modulated output power light.

The signals to be transmitted are, in a preferred embodiment, analog signals.

The modulated output power light has, in a preferred embodiment, a linear relationship with said signals to be transmitted.

Preferred examples of
/ the invention described herein make possible the objects of (1) providing a signal modulation mode of semiconductors in which a high-frequency signal current, the amplitude of which is modulated by signals to be transmitted, and a semiconductor laser with a bias current, set at around the threshold current level, is modulated with regard to current by the said modulated high-frequency signal current, thereby attaining analog transmission of the semiconductor laser with reduced noise and with an excellent linearity; and (2) providing a signal modulation mode of semiconductor lasers for analog transmission in which a high-frequency signal current which has been amplitude-modulated to a great extent at around the threshold current level by signals to be transmitted is applied to a semiconductor laser, and thus even a single longitudinal mode semiconductor laser lases in multi longitudinal modes so that modal and reflection noise can be suppressed and an output power light with an excellent linearity can be obtained.

This invention may be better understood and its numerous advantages will become apparent to those skilled in the art by reference to the accompanying drawings as follows:

Figures 1(A) and 1(B) are schematic diagrams showing a signal modulation mode of semiconductor lasers according to this invention.

Figures 2 and 3 are schematic diagrams showing a conventional analog modulation mode of semiconductor lasers.

Figure 4 is a circuit diagram providing the modulation mode shown in Figure 3.

Figure 5 is a circuit diagram providing the modulation mode shown in Figures 1(A) and 1(B).

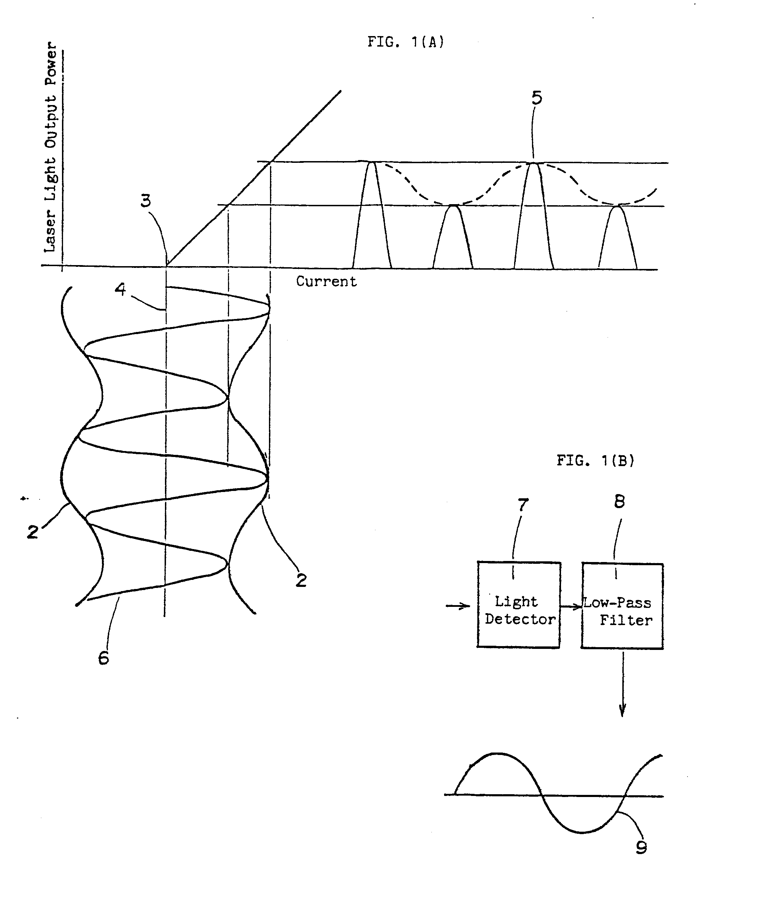

Figures 1(A) and 1(B) show a signal modulation mode for a semiconductor laser according to this invention, Figure 1(A) showing the characteristic curves of the relationship between the current and the laser light output power of a semiconductor laser and the relationship between the input current curve and the output light curve of the semiconductor laser. A high-frequency current 6, which has been sandwiched between the analog signals 2 with a pair of reciprocal phases to achieve amplitude-modulation, is superposed on the analog signals 2 to be fed into the semiconductor laser and applied to the semiconductor laser. The frequency of the high-frequency current 6 is significantly higher than that of the analog signals 2. The bias current 4 of the semiconductor laser is set at around the threshold current level 3. When the high-frequency current 6, the amplitude of which is modulated by the analog signals 2, is applied to the semiconductor laser, a light output power pulse curve 5 is obtained with an equal space at the intersections of the abscissa (i.e., the zero-line of the laser light output power) with the pulse curves, so that the duty cycle of the laser light output pulse 5 is maintained constant regardless of a change of the input analog signals 2. That is, the high-frequency current having amplitude, the center (i.e., the zero-line) of which matches the bias current value set at the threshold current value, is modulated with regard to amplitude by the analog signals 2 and then fed into the semiconductor laser, resulting in the laser light output power pulse 5 having a regular duty cycle. Only amplitude of the pulse 5 exhibits a modulated curve corresponding to the analog signals 2.

The output laser light is, as shown in Figure 1(B), introduced into a light detector 7 on the receiving side to be converted into a receiving signal current, which is then fed into a low-pass filter 8 from which a signal component 9 is received. The signal 9 is considered to be a changes over time of the integrated value of the laser light output power pulse 5, having an excellent linearity against the analog signals 2.

Figure 5 shows a circuit diagram for achieving the modulation mode shown in Figures 1(A) and 1(B), wherein a bias current set at around the threshold current is fed from a bias-current generator 14 to a semiconductor laser 10 via a coupling inductor 15, and moreover a multiplier 16 is connected to the semiconductor laser 10 via a coupling condenser 13. The multiplier 16 releases the product of the analog signal (1+mcosWst) to which a bias current is added to be transmitted and the high-frequency signal (VccosWct), thereby applying a modulation signal to the semiconductor laser 10.

When the semiconductor laser 10 is driven with a pulse by the application of the high-frequency current thereto, it is changed from a longitudinal mode to multi longitudinal modes at the initial stage of the pulse application, thereby achieving lasing in the multi longitudinal modes. When the semiconductor laser 10 is driven by the high-frequency signal (VccosWct) using the above-mentioned mode-changing process, deterioration of the signal curve resulting from either modal or reflection noise is prevented. Moreover, when the high-frequency signal is modulated with regard to amplitude by the analog signal (1+mcosWst) to be transmitted and then fed into the

0189295

- 7 -

semiconductor laser **10**, a laser light output power signal with an improved linearity is obtained. In this manner, a modulation mode having excellent transmission characteristics can be obtained.

It is understood that various other modifications will be apparent to and can be readily made by those skilled in the art without departing from the scope and spirit of this invention. Accordingly, it is not intended that the scope of the claims appended hereto be limited to the description as set forth herein, but rather that the claims be construed as encompassing all the features of patentable novelty which reside in the present invention, including all features which would be treated as equivalents thereof by those skilled in the art to which this invention pertains.

Claims:

1. A signal modulation mode for a semiconductor laser, wherein a high-frequency signal current which is amplitude-modulated by signals to be transmitted is applied to the semiconductor laser with a bias current set at around the threshold current level, resulting in a modulated output power light.

2. A signal modulation mode for a semiconductor laser according to claim 1, wherein said signals to be transmitted are analog signals.

3. A signal modulation mode for a semiconductor laser according to claim 1 or 2, wherein said modulated output power light has a linear relationship with said signals to be transmitted.

4. A circuit adapted and arranged for modulating a semiconductor laser in a mode as claimed in any preceding claim.

FIG. 1(A)

FIG. 1(B)

FIG. 2

FIG. 3

4/4

FIG. 4

High-Frequency Signal Generator — 12

13

11 — Driving Circuit

10

FIG. 5

16

Vc (1+ mcos Wst) cos Wst

Multi-plier

(1+ mcos Wst)

Vc cos Wct

13

15

14 — Bias-Current Generator

10